Europäisches Patentamt

**European Patent Office**

**Office européen des brevets**

(11) Veröffentlichungsnummer: **0 092 711**
**B2**

(12) **NEUE EUROPÄISCHE PATENTSCHRIFT**

(45) Veröffentlichungstag der neuen Patentschrift:
26.07.89

(51) Int. Cl.⁴: **H 03 K 17/945**

(21) Anmeldenummer: **83103394.9**

(22) Anmeldetag: **07.04.83**

(54) **Elektronisches, vorzugsweise berührungslos arbeitendes Schaltgerät.**

(30) Priorität: **21.04.82 DE 3214836**

(43) Veröffentlichungstag der Anmeldung:
**02.11.83 Patentblatt 83/44**

(45) Bekanntmachung des Hinweises auf die Patenterteilung:
**04.09.85 Patentblatt 85/36**

(45) Bekanntmachung des Hinweises auf die Entscheidung
über den Einspruch:
**26.07.89 Patentblatt 89/30**

(84) Benannte Vertragsstaaten:
**AT BE CH DE FR GB IT LI LU NL SE**

(56) Entgegenhaltungen:
**DE-A- 3 123 828**
**DE-A- 3 123 828**
**DE-C- 2 628 427**
**JP-A-32 000 131**

**Patent Abstracts of Japan, vol.6, no.99 (E-111) 977,8th.
june 1982, Yamatake, Honeywell KK**

(73) Patentinhaber: **i f m electronic gmbh, Teichstrasse 4,
D-4300 Essen 1 (DE)**

(72) Erfinder: **Buck, Robert, Ing. (grad.), Am Kirchbühl 28,
D-7995 Neukirch (DE)**
Erfinder: **Lamarche, Jean Luc, Ing. (grad.),
Zeppelinstrasse 1, D-7974 Langenargen (DE)**

(74) Vertreter: **Gesthuysen, Hans Dieter, Dipl.-Ing. et al,
Patentanwälte Gesthuysen + von Rohr
Huyssenallee 15 Postfach 10 13 33, D-4300 Essen 1 (DE)**

## Beschreibung

Die Erfindung betrifft ein elektronisches, vorzugsweise berührungslos arbeitendes Schaltgerät für eine Wechselspannung führende Betriebsspannungsquelle, mit einem von außen beeinflußbaren Anwesenheitsindikator, z.B. einem Oszillator, mit einem exklusiven ODER-Gatter, mit einem von dem Anwesenheitsindikator über das exklusive ODER-Gatter steuerbaren elektronischen Schalter, z.B. einem Thyristor, einem Transistor oder einem Triac, mit einer Gleichrichterbrücke mit vier Gleichrichterelementen, mit zwei weiteren Gleichrichterelementen sowie mit einem ersten, einem zweiten und einem dritten Schaltgeräteanschluß, wobei der erste Eingang des exklusiven ODER-Gatters an den Ausgang des Anwesenheitsindikators oder eines dem Anwesenheitsindikator nachgeschalteten Schaltverstärkers angeschlossen ist, der zweite Eingang des exklusiven ODER-Gatters mit einem Umkehrsteuersignal beaufschlagbar ist und der Ausgang des exklusiven ODER-Gatters an den Steuereingang des elektronischen Schalters angeschlossen ist, wobei ferner die beiden weiteren Gleichrichterelemente jeweils einerseits mit zwei Gleichrichterelementen der Gleichrichterbrücke und andererseits mit dem dritten Schaltgeräteanschluß verbunden sind und wobei schließlich am zweiten Eingang des exklusiven ODER-Gatters dann, wenn der erste und der zweite Schaltgeräteanschluß an die Betriebsspannungsquelle angeschlossen sind, das Umkehrsteuersignal ansteht, und dann, wenn der erste und der dritte Schaltgeräteanschluß an die Betriebsspannungsquelle angeschlossen sind, kein Umkehrsteuersignal ansteht oder umgekehrt, nämlich der zweite Eingang des exklusiven ODER-Gatters einerseits – vorzugsweise über einen Strombegrenzungswiderstand – an das das Umkehrsteuersignal darstellende Pluspotential einer Hilfsspannungsquelle angeschlossen ist und andererseits dadurch, daß der erste und der dritte Schaltgeräteanschluß an die Betriebsspannungsquelle angeschlossen werden, an das Minuspotential der Hilfsspannungsquelle anschließbar ist.

Elektronische Schaltgeräte der zuvor beschriebenen Art sind kontaktlos ausgeführt und werden in zunehmendem Maße anstelle von elektrischen, mechanisch betätigten Schaltgeräten, die kontaktbehaftet ausgeführt sind, in elektrischen Meß-, Steuer- und Regelkreisen verwendet. Das gilt insbesondere für sogenannte Annäherungsschalter, d.h. für elektronische Schaltgeräte, die berührungslos arbeiten. Mit solchen Annäherungsschaltern wird indiziert, ob sich ein Beeinflussungselement, für das der entsprechende Annäherungsschalter sensitiv ist, dem Annäherungsschalter hinreichend weit genähert hat. Hat sich nämlich ein Beeinflussungselement, für das der entsprechende Annäherungsschalter sensitiv ist, dem Anwesenheitsindikator hinreichend weit genähert, so steuert der Anwesenheitsindikator den elektronischen Schalter um, d.h. bei einem als Schließer ausgeführten Schaltgerät wird der nichtleitende elektronische Schalter nunmehr leitend, während bei einem als Öffner ausgeführten Schaltgerät der leitende elektronische Schalter nunmehr sperrt. (Mit Schaltgeräten der in Rede stehenden Art kann auch indiziert werden, ob eine physikalische Größe eines Beeinflussungsmediums, für die das Schaltgerät sensitiv ist, einen entsprechenden Wert erreicht hat).

Wesentlicher Bestandteil von elektronischen Schaltgeräten der zuvor beschriebenen Art ist also u.a. der von außen beeinflußbare Anwesenheitsindikator. Als Anwesenheitsindikator kann z.B. ein induktiv oder kapazitiv beeinflußbarer Oszillator vorgesehen sein; es handelt sich dann um induktive oder kapazitive Annäherungsschalter (vgl. z.B. die deutschen Offenlegungsschriften bzw. Auslegeschriften bzw. Patentschriften 1 951 137, 1 966 178, 1 966 213, 2 036 840, 2 127 956, 2 203 038, 2 203 039, 2 203 040, 2 203 906, 2 330 233, 2 331 732, 2 356 490, 2 613 423, 2 616 265, 2 616 773, 2 628 427, 2 711 877 und 2 744 785). Als Anwesenheitsindikator kann z.B. auch ein Fotowiderstand, eine Fotodiode oder ein Fototransistor vorgesehen sein; es handelt sich dann um optoelektronische Annäherungsschalter (vgl. z.B. die deutsche Offenlegungsschrift 2 824 582).

Bei induktiven Annäherungsschaltern gilt für den Oszillator, solange ein Metallteil einen vorgegebenen Abstand noch nicht erreicht hat, $k \cdot V = 1$ mit $K$ = Rückkopplungsfaktor und $V$ = Verstärkungsfaktor des Oszillators, d.h. der Oszillator schwingt. Erreicht das entsprechende Metallteil den vorgeschriebenen Abstand, so führt die zunehmende Bedämpfung des Oszillators zu einer Verringerung des Verstärkungsfaktors $V$, so daß $K \cdot V < 1$ wird, d.h. der Oszillator hört auf zu schwingen. Bei kapazitiven Annäherungsschaltern gilt für den Oszillator, solange ein Ansprechkörper die Kapazität zwischen einer Ansprechelektrode und einer Gegenelektrode noch nicht hinreichend vergrößert hat, also einen vorgegebenen Abstand noch nicht erreicht hat, $K \cdot V < 1$, d.h. der Oszillator schwingt nicht. Erreicht der Ansprechkörper den vorgegebenen Abstand, so führt die steigende Kapazität zwischen der Ansprechelektrode und der Gegenelektrode zu einer Vergrößerung des Rückkopplungsfaktors $K$, so daß $K \cdot V = 1$ wird, d.h. der Oszillator beginnt zu schwingen. Bei beiden Ausführungsformen wird unabhängig von den unterschiedlichen Zuständen des Oszillators der elektronische Schalter, z.B. ein Transistor, ein Thyristor oder ein Triac, gesteuert.

Optoelektronische Annäherungsschalter weisen einen Lichtsender und einen Lichtempfänger auf und werden auch als Lichtschranken bezeichnet. Dabei unterscheidet man zwischen einem Lichtschrankentyp, bei dem der Lichtsender und der Lichtempfänger auf entgegengesetzten Seiten einer Überwachungsstrecke angeordnet sind, und einem Lichtschrankentyp, bei dem der Lichtsender und der Lichtempfänger am gleichen Ende einer Überwachungsstrecke angeordnet sind, während ein am anderen Ende der Überwachungsstrecke angeordneter Reflektor den vom Lichtsender ausgehenden Lichtstrahl zum Lichtempfänger zurückreflektiert. In beiden Fällen spricht der Anwesenheitsindikator an, wenn der normalerweise vom Lichtsender zum Lichtempfänger gelangende Lichtstrahl durch ein in die Überwachungsstrecke gelangtes Beeinflussungselement unterbrochen wird. Es gibt jedoch auch Lichtschranken des zuletzt beschriebenen Lichtschrankentyps, bei dem der vom Lichtsender kommende Lichtstrahl nur durch ein entsprechendes Beeinflussungselement zum Lichtempfänger zurückreflektiert wird.

Elektronische, berührungslos arbeitende Schaltgeräte sind anfangs mit einer Reihe von Problemen behaftet gewesen, – gemessen an elektrischen, mechanisch betätigten Schaltgeräten –, nämlich u. a. mit den Problemen «Erzeugung einer Speisespannung für den Oszillator», «Ausbildung des Oszillators», «Einschaltimpulsverhinderung», «Kurzschlußfestigkeit». Mit diesen Problemen und deren Lösungen (und mit anderen bei elektronischen, berührungslos arbeitenden Schaltgeräten relevanten Problemen und deren Lösungen) befassen sich z.B. die deutschen Offenlegungsschriften bzw. Auslegeschriften bzw. Patentschriften 1 951 137, 1 966 178, 1 966 213, 2 036 840, 2 127 956, 2 203 038, 2 203 039, 2 203 040, 2 203 906, 2 330 233, 2 331 732, 2 356 490, 2 613 423, 2 616 265, 2 616 773, 2 628 427, 2 711 877, 2 744 785, 2 943 911, 3 004 829, 3 038 102, 3 038 141 und 3 038 692.

Wie bereits angedeutet, werden elektronische Schaltgeräte der in Rede stehenden Art, wie elektrische Schaltgeräte auch, als Schließer oder als Öffner benötigt und gebaut. Die Notwendigkeit, elektronische Schaltgeräte der in Rede stehenden Art sowohl als Schließer als auch als Öffner bauen und lagermäßig bereithalten zu müssen, ist aufwendig, – was einer näheren Erläuterung nicht bedarf.

Aus der DE-PS 2 628 427, deren Offenbarungsgehalt hiermit ausdrücklich auch hier zur Offenbarung gemacht wird, ist es bekannt, bei einem elektronischen Schaltgerät der in Rede stehenden Art, und zwar konkret bei einem Schaltgerät mit einem von außen beeinflußbaren Oszillator und einem von dem Oszillator steuerbaren Thyristor, zwischen dem Oszillator und der Zündelektrode des Thyristors ein exklusives ODER-Gatter zu schalten, derart, daß der erste Eingang des exklusiven ODER-Gatters an den Ausgang des Oszillators oder eines dem Oszillator nachgeschalteten Schaltverstärkers angeschlossen, der zweite Eingang des exklusiven ODER-Gatters mit einem Umkehrsteuersignal beaufschlagbar und der Ausgang des exklusiven ODER-Gatters an die Zündelektrode des Thyristors angeschlossen ist. Dadurch ist die Aufgabe gelöst, ein elektronisches Schaltgerät der in Rede stehenden Art anzugeben, das sowohl als Schließer als auch als Öffner benutzt und durch eine einfache Maßnahme am fertigen Schaltgerät zu einem Öffner bzw. zu einem Schließer gemacht werden kann. Im einzelnen ist dabei vorgesehen, daß der zweite Eingang des exklusiven ODER-Gatters über einen Strombegrenzungswiderstand an das das Umkehrsteuersignal darstellende Pluspotential einer Hilfsspannungsquelle angeschlossen und mit dem Minuspotential der Hilfsspannungsquelle verbindbar ist. Ist der zweite Eingang des exklusiven ODER-Gatters mit dem Minuspotential der Hilfsspannungsquelle verbunden, so ist am zweiten Eingang des exklusiven ODER-Gatters ein Umkehrsteuersignal nicht wirksam. Wird jedoch die Verbindung des zweiten Eingangs des exklusiven ODER-Gatters mit dem Minuspotential der Hilfsspannungsquelle unterbrochen, so wird am zweiten Eingang des exklusiven ODER-Gatters das Pluspotential der Hilfsspannungsquelle als Umkehrsteuersignal wirksam. Durch die Unterbrechung bzw. die Herstellung einer Verbindung ist also das in Rede stehende Schaltgerät «programmierbar», z.B. nämlich als Schließer oder als Öffner.

Im übrigen sind elektronische Schaltgeräte der in Rede stehenden Art bekannt, die einen Anwesenheitsindikator mit zwei antivalenten Ausgängen und zwei elektronischen Schaltern aufweisen (vgl. die DE-ASen 2 931 879 und 2 931 880). Hier sind gleichsam zwei Schaltgeräte, nämlich ein als Schließer ausgeführtes Schaltgerät und ein als Öffner ausgeführtes Schaltgerät, zu einem Doppel-Schaltgerät vereinigt, – wobei beiden Schaltgeräten ein Anwesenheitsindikator gemeinsam ist. Dieses Doppel-Schaltgerät ist jedoch insoweit aufwendig, als es zwei elektronische Schalter – und dann, wenn es für eine Wechselspannung führende Betriebsspannungsquelle verwendbar sein soll, auch zwei Gleichrichterbrücken benötigt.

Das bekannte elektronische Schaltgerät, von dem die Erfindung ausgeht (vgl. die JP-AS 57-32 131), ist in bezug auf seine «Programmierbarkeit», also in bezug auf die Möglichkeit der Realisierung als Schließer oder als Öffner, gegenüber dem weiter oben beschriebenen Schaltgerät noch weiter vereinfacht. Bei diesem Schaltgerät ist nämlich gleichsam eine «Anschlußprogrammierbarkeit» gegeben, d.h. eine automatische Realisierung als Schließer oder als Öffner, nämlich dadurch, daß dieses Schaltgerät als Schließer angeschlossen wird – Anschluß mit Hilfe des ersten und des zweiten Schaltgeräteanschlusses – oder als Öffner angeschlossen wird – Anschluß mit Hilfe des ersten und des dritten Schaltgeräteanschlusses.

Im einzelnen ist bei dem elektronischen Schaltgerät, von dem die Erfindung ausgeht, zunächst an den zweiten Eingang des exklusiven ODER-Gatters der Kollektor eines Schalttransistors angeschlossen, dessen Emitter an das Minuspotential der Hilfsspannung angeschlossen ist. Im übrigen liegt zwischen dem dritten Schaltgeräteanschluß und dem Minuspotential der Hilfsspannung die Reihenschaltung aus einer Diode, einem ersten Widerstand und einem zweiten Widerstand. An die Verbindung dieser beiden Widerstände ist – über einen weiteren Widerstand – die Basis des Schalttransistors angeschlossen. Die zuvor erläuterte Schaltung hat zur Folge, daß dann, wenn der dritte Schaltgeräteanschluß benutzt wird, ein von der Betriebsspannung und den beiden in Reihe geschalteten Widerständen abhängiger Zusatzstrom fließt, der unerwünscht ist, weil elektronische Schaltgeräte der in Rede stehenden Art einen möglichst geringen Leerlaufstrom haben sollen.

Der Erfindung liegt folglich die Aufgabe zugrunde, anzugeben, wie das im Stand der Technik bekannte, zuvor beschriebene elektronische Schaltgerät auszugestalten und weiterzubilden ist, damit dieses Schaltgerät einen geringeren Leerlaufstrom aufnimmt.

Das erfindungsgemäße Schaltgerät, bei dem die zuvor hergeleitete und dargelegte Aufgabe gelöst ist, ist nun dadurch gekennzeichnet, daß der zweite Eingang des exklusiven ODER-Gatters an die Anode einer Umkehrsteuerdiode und die Kathode der Umkehrsteuerdiode an den dritten Schaltgeräteanschluß angeschlossen wird. Dadurch ist erreicht, daß dann, wenn der dritte Schaltgeräteanschluß benutzt wird, kein von der Betriebsspannung abhängiger Zusatzstrom fließt.

Im folgenden wird die Erfindung anhand einer lediglich Ausführungsbeispiele darstellenden Zeichnung nochmals erläutert; es zeigt:

Fig. 1 das Blockschaltbild eines erfindungsgemäßen elektronischen, berührungslos arbeitenden Schaltgerätes, und zwar eines Wechselspannungsgerätes und

Fig. 2 das Schaltbild des Schaltgerätes nach Fig. 1.

Das in den Figuren dargestellte elektronische Schaltgerät 1 arbeitet berührungslos und besteht im wesentlichen aus einem von außen beeinflußbaren Anwesenheitsindikator 2, im dargestellten Ausführungsbeispiel einem Oszillator, aus einem von dem Anwesenheitsindikator 2 steuerbaren elektronischen Schalter 3, im Ausührungsbeispiel einem Thyristor und aus einem zwischen dem Anwesenheitsindikator 2 und dem Steuereingang 4 des elektronischen Schalters 3 vorgesehenen exklusiven ODER-Gatter 5. Dabei ist der erste Eingang 6 des exklusiven ODER-Gatters 5 an den Ausgang 7 eines dem Anwesenheitsindikator 2 nachgeschalteten Schaltverstärkers 8 angeschlossen, der zweite Eingang 9 des exklusiven ODER-Gatters 5 mit einem Umkehrsteuersignal beaufschlagbar und der Ausgang 10 des exklusiven ODER-Gatters 5 an den Steuereingang 4 des elektronischen Schalters 3 angeschlossen und sind ein erster und zweiter Schaltgeräteanschluß 11, 12 vorgesehen.

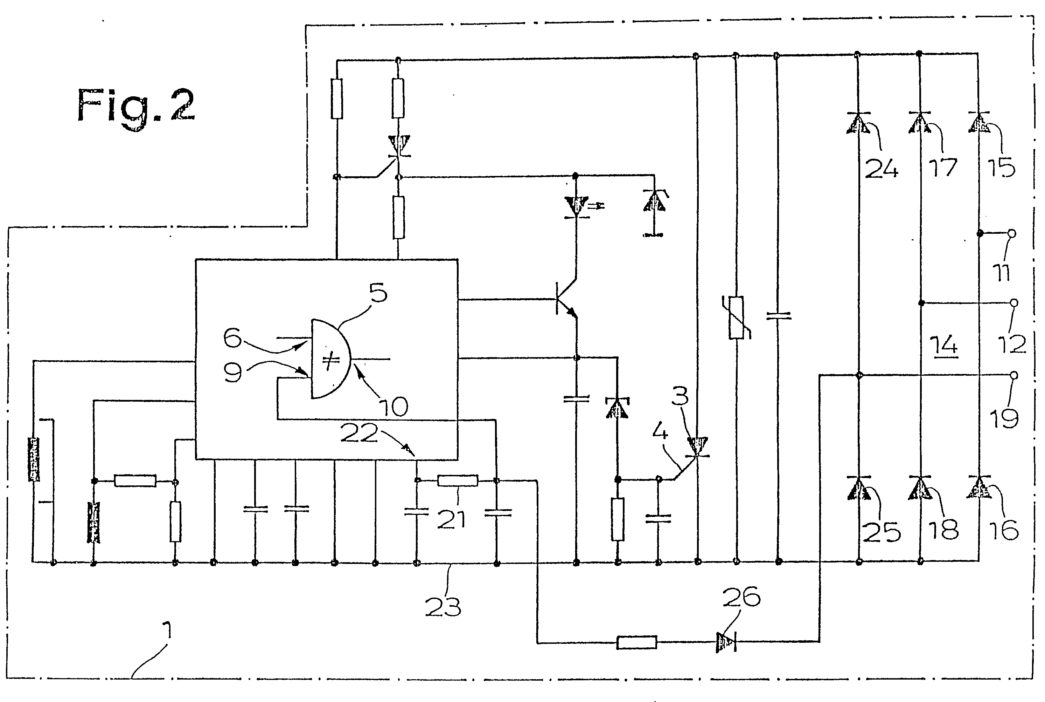

Da es sich bei dem erfindungsgemäßen Schaltgerät um ein Wechselspannungsgerät handelt, ist noch eine Hilfsspannungsquelle 13 angedeutet und eine Gleichrichterbrücke 14 mit vier Gleichrichterelementen 15, 16, 17, 18 vorgesehen. Im übrigen zeigt die Fig. 2 Schaltungsdetails des Aufbaus eines elektronischen Schaltgerätes, die hier der Erläuterung nicht bedürfen.

Bei dem in Rede stehenden elektronischen Schaltgerät 1 ist ein dritter Schaltgeräteanschluß 19 vorgesehen und steht am zweiten Eingang 9 des exklusiven ODER-Gatters 5 dann, wenn der erste und der zweite Schaltgeräteanschluß 11, 12 an die Betriebsspannungsquelle 20 angeschlossen sind, das Umkehrsteuersignal an, während dann, wenn der erste und der dritte Schaltgeräteanschluß 11, 19 an die Betriebsspannungsquelle 20 angeschlossen sind, am zweiten Eingang 9 des exklusiven ODER-Gatters 5 kein Umkehrsteuersignal ansteht (oder umgekehrt). Der zweite Eingang 9 des exklusiven ODER-Gatters 5 ist einerseits über einen Strombegrenzungswiderstand 21 an das das Umkehrsteuersignal darstellende Pluspotential 21 der Hilfsspannungsquelle 13 angeschlossen und andererseits dadurch, daß der erste und der dritte Schaltgeräteanschluß 11, 19 an die Betriebsspannungsquelle 20 angeschlossen werden, an das Minuspotential 23 der Hilfsspannungsquelle 13 anschließbar. Eingangsseitig sind zwei weitere Gleichrichterelemente 24, 25 vorgesehen und jeweils einerseits mit zwei anderen Gleichrichterelementen 15, 17 bzw. 16, 18 und andererseits mit dem dritten Schaltgeräteanschluß 19 verbunden, und der zweite Eingang 9 des exklusiven ODER-Gatters 5 ist mit dem dritten Schaltgeräteanschluß 19 verbunden ist, und zwar über eine Umkehrsteuerdiode 26. Im einzelnen sind der zweite Eingang 9 des exklusiven ODER-Gatters 5 an die Anode der Umkehrsteuerdiode 26 und die Kathode der Umkehrsteuerdiode 26 an den dritten Schaltgeräteanschluß 19 angeschlossen.

Im folgenden soll nun die Funktionsweise der erfindungsgemäß realisierten «Anschlußprogrammierbarkeit» erläutert werden:

Durch den im einzelnen nicht dargestellten bzw. im einzelnen nicht beschriebenen Anwesenheitsindikator 2 ist in Verbindung mit dem im einzelnen nicht dargestellten bzw. im einzelnen nicht beschriebenen Schaltverstärker 8 das Schaltgerät 1 als Schließer wirksam, wenn am zweiten Eingang 9 des exklusiven ODER-Gatters 5 ein Umkehrsteuersignal ansteht. Steht dagegen am zweiten Eingang 9 des exklusiven ODER-Gatters 5 kein Umkehrsteuersignal an, so hat das Schaltgerät 1 die Funktion eines Öffners. (Hier wird in bezug auf das exklusive ODER-Gatter 5 nochmals auf die DE-PS 2 628 427 verwiesen, und zwar auf die Wahrheitstabelle in Spalte 2).

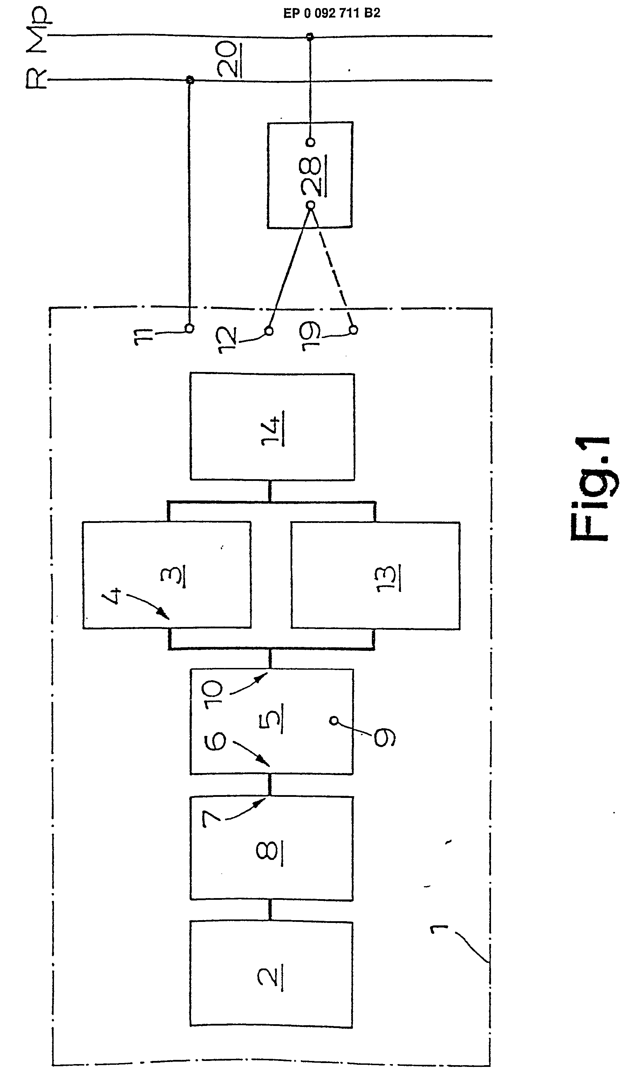

Ist nun das erfindungsgemäße Schaltgerät 1 mit dem ersten Schaltgeräteanschluß 11 – direkt – und mit dem zweiten Schaltgeräteanschluß 12 – über einen in Fig. 1 dargestellten Verbraucher 28 – an die Betriebsspannungsquelle 20 angeschlossen, hängt also der dritte Schaltgeräteanschluß 19 «in der Luft», so steht am zweiten Eingang 9 des exklusiven ODER-Gatters 5 – über den Strombegrenzungswiderstand 21 – das das Umkehrsteuersignal darstellende Pluspotential 22 der Hilfsspannungsquelle 13 an. Das Schaltgerät 1 arbeitet also als Schließer, wenn es über den ersten und den zweiten Schaltgeräteanschluß 11, 12 an die Betriebsspannungsquelle 20 angeschlossen wird bzw. ist.

Wird jedoch das Schaltgerät 1 mit dem ersten Schaltgeräteanschluß 11 – direkt – und mit dem dritten Schaltgeräteanschluß 19 – über den Verbraucher 28, wie gestrichelt in Fig. 1 dargestellt – an die Betriebsspannungsquelle 20 angeschlossen, so wird damit der zweite Eingang 9 des exklusiven ODER-Gatters 5 – über die Umkehrsteuerdiode 26 – praktisch an das Minuspotential 23 der Hilfsspannungsquelle 13 angeschlossen, so daß am zweiten Eingang des exklusiven ODER-Gatters 5 kein Umkehrsignal mehr ansteht. Das Schaltgerät 1 arbeitet also als Öffner, wenn es über den ersten und den dritten Schaltgeräteanschluß 11, 19 an die Betriebsspannungsquelle 20 angeschlossen wird bzw. ist.

**Patentanspruch**

Elektronisches, vorzugsweise berührungslos arbeitendes Schaltgerät für eine Wechselspannung führende Betriebsspannungsquelle, mit einem von außen beeinflußbaren Anwesenheitsindikator, z.B. einem Oszillator, mit einem exklusiven ODER-Gatter, mit einem von dem Anwesenheitsindikator über das exklusive ODER-Gatter steuerbaren elektronischen Schalter, z.B. einem Thyristor, einem Transistor oder einem Triac, mit einer Gleichrichterbrücke mit vier Gleichrichterelementen, mit zwei weiteren Gleichrichterelementen sowie mit einem ersten, einem zweiten und einem dritten Schaltgeräteanschluß, wobei der erste Eingang des exklusiven ODER-Gatters an den Ausgang des Anwesenheitsindikators oder eines dem Anwesenheitsindikator nachgeschalteten Schaltverstärkers angeschlossen ist, der zweite Eingang des exklusiven ODER-Gatters mit einem Umkehrsteuersignal beaufschlagbar ist und der Ausgang des exklusiven ODER-Gatters an den Steuereingang des elektronischen Schalters angeschlossen ist, wobei ferner die beiden weiteren Gleichrichterelemente jeweils einerseits mit zwei Gleichrichterelementen der Gleichrichterbrücke und andererseits mit dem dritten Schaltgeräteanschluß berbunden sind und wobei schließlich am zweiten Eingang des exklusiven ODER-Gatters dann, wenn der erste und der zweite Schaltgeräteanschluß an die Betriebsspannungsquelle angeschlossen sind, das Umkehrsteuersignal ansteht, und dann, wenn der erste und der dritte Schaltgeräteanschluß an die Betriesspannungsquelle angeschlossen sind, kein Umkehrsteuersignal ansteht oder umgekehrt, nämlich der zweite Eingang des exklusiven ODER-Gatters einerseits – vorzugsweise über einen Strombegrenzungswiderstand – an das das Umkehrsteuersignal darstellende Pluspotential einer Hilfsspannungsquelle angeschlossen ist und andererseits dadurch, daß der erste und der dritte Schaltgeräteanschluß an die Betriebsspannungsquelle angeschlossen werden, an das Minuspotential der Hilfsspannungsquelle anschließbar ist, dadurch gekennzeichnet, daß der zweite Eingang (9) des exklusiven ODER-Gatters (5) an die Anode einer Umkehrsteuerdiode (26) und die Kathode der Umkehrsteuerdiode (26) an den dritten Schaltgeräteanschluß (19) angeschlossen sind.

**Claim**

An electronic switching equipment, preferably working without contact, for a source of operating voltage supplying alternating voltage, with a proximity indicator, e.g. an oscillator, that can be influenced from outside, with an exclusive OR-gate, with an electronic switch e.g. a thyristor, a transistor or a triac, that can be controlled from the presence indicator via the exclusive OR-gate, with a rectifier bridge having four rectifier units, with two further rectifier units and with a first, a second and a third switching equipment connection, in which the first input of the exclusive OR-gate is connected to the output of the presence indicater or of a switching amplifier connected in series with the presence indicator, the second input of the exclusive OR-gate can be acted upon by a reversing control signal, and the output of the exclusive OR-gate is connected to the control input of the electronic switch, in which in addition each of the two further rectifier units is connected on one side to two rectifier units of the rectifier bridge and on the other side to the third switching equipment connection, and finally in which when the first and second switching equipment connections are connected to the source of operating voltage the reversing control signal appears at the second input of the exclusive OR-gate, and when the first and the third switching equipment connections are connected to the source of operating voltage no reversing control signal appears, or expressed in the reverse manner the second input of the exclusive OR-gate is connected on one hand — preverably via a currentlimiting resistance — to the positive potential, representing the reversing control signal, of a source of auxiliary voltage, and on the other hand when the first and third switching equipment connections are connected to the source of operating voltage the second input of the exclusive OR-gate can be connected to the negative potential of the source of auxiliary voltage, characterized in that the second input (9) of the exclusive OR-gate (5) is connected to the anode of a reversing control diode (26) and the cathode of the reversing control diode (26) is connected to the third switching equipment connection (19).

**Revendication**

Appareil de commutation électronique, fonctionnant de préférence sans contact, pour une source de tension de service de type alternatif, équipé d'un indicateur de présence pouvant être influencé de l'extérieur, par exemple un oscillateur, d'une porte OU exclusif, d'un contacteur électronique, par exemple un thyristor, un transistor ou un triac, pouvant être commandé par l'indicateur de présence par l'intermédiaire de la porte OU exclusif, d'un pont redresseur avec quatre éléments redresseurs, de deux éléments redresseurs supplémentaires ainsi que d'un premier, d'un deuxième et d'un troisième reccordements d'appareil de commutation, la première entrée de la porte OU exclusif étant reliée à la sortie de l'indicateur de présence ou d'un amplificateur de circuit monté en aval de l'indicateur de présence, la deuxième entrée de la porte OU exclusif pouvant être alimentée par un signal d'inversion et la sortie de la porte OU exclusif étant raccordée à l'entrée de commande du contacteur électronique, les deux éléments redresseurs supplémentaires étant, en outre, reliés chacun à deux éléments redresseurs du pont redresseur d'un part et au troisième raccordement de l'appareil de commutation d'autre part et, enfin, le signal d'inversion étant appliqué à la deuxième entrée de la porte OU exclusif lorsque les premiers et deuxièmes raccordements de l'appareil de commutation sont reliés à la source de tension de service, alors qu'aucun signal d'inversion n'est appliqué lorsque les premier et troisième raccordements de l'appareil de commutation sont reliés à la source de tension de service, ou inversement, à savoir que la deuxième entrée de la porte OU exclusif est reliée d'une part – de préférence par l'intermédiaire d'une résistance limitrice de courant – au potentiel positif d'une source de tension auxiliaire représentant le signal d'inversion et peut être reliée d'autre part au potentiel négatif de la source de tension auxiliaire étant donné que les premier et troisième raccordements de l'appareil de commutation sont reliés à la source de tension de service, caractérisé en ce que la deuxième entrée (9) de la porte OU exclusif (5) est reliée à l'anode d'une diode de découplage (26) et que la cathode de la diode de découplage (26) est reliée au troisième raccordement (19) de l'appareil de commutation.

Fig.1

EP 0 092 711 B2

# Fig.2

EP 0 092 711 B2